(19) **Europäisches Patentamt / European Patent Office / Office européen des brevets**

(11) **EP 4 150 358 B1**

(12) **FASCICULE DE BREVET EUROPEEN**

(45) Date de publication et mention de la délivrance du brevet:
**02.07.2025 Bulletin 2025/27**

(21) Numéro de dépôt: **21725149.5**

(22) Date de dépôt: **11.05.2021**

(51) Classification Internationale des Brevets (IPC):
**G01R 31/52** *(2020.01)* **G01R 31/08** *(2020.01)*

(52) Classification Coopérative des Brevets (CPC):
**G01R 31/52; G01R 31/081**

(86) Numéro de dépôt international:
**PCT/EP2021/062409**

(87) Numéro de publication internationale:
**WO 2021/228806 (18.11.2021 Gazette 2021/46)**

(54) **PROCÉDÉ DE SURVEILLANCE D'UN SYSTÈME DE TRANSPORT D'ÉNERGIE ÉLECTRIQUE ET DISPOSITIF ASSOCIÉ**

VERFAHREN ZUR ÜBERWACHUNG EINES SYSTEMS ZUR ÜBERTRAGUNG VON ELEKTRISCHER ENERGIE UND ZUGEHÖRIGE VORRICHTUNG

METHOD FOR MONITORING A SYSTEM FOR TRANSMITTING ELECTRICAL POWER AND ASSOCIATED DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.05.2020 FR 2004784**

(43) Date de publication de la demande:
**22.03.2023 Bulletin 2023/12**

(73) Titulaire: **Supergrid Institute**
**69100 Villeurbanne (FR)**

(72) Inventeurs:
- **HENRIKSEN, Martin Molby**
  **69007 LYON (FR)**
- **BOYER, Ludovic Stéphane**
  **42800 SAINT JOSEPH (FR)**

(74) Mandataire: **Opilex**
**32, rue Victor Lagrange**
**69007 Lyon (FR)**

(56) Documents cités:
**US-A1- 2011 218 790    US-A1- 2020 116 776**

## Description

Le domaine de la présente invention est relatif au transport d'électricité dans les réseaux de transport à courant continu notamment à haute tension (High Voltage Direct Current (HVDC) en anglais) et plus particulièrement à un procédé de surveillance d'un tel câble de transport d'énergie électrique afin de permettre de détecter un défaut au niveau dudit câble de transport d'énergie électrique.

Le développement actuel des énergies renouvelables provoque de nouvelles contraintes au niveau du réseau électrique car les différents lieux de production d'électricité sont généralement éloignés les uns des autres et éloignés des zones de consommation. Il apparaît donc nécessaire de développer de nouveaux réseaux de transport capables de transporter de l'électricité sur de très longues distances tout en minimisant les pertes d'énergie.

Pour répondre à ces contraintes, les réseaux haute tension (par exemple 320kV) à courant continu (High Voltage Direct Curent (HVDC) en anglais) apparaissent comme une solution prometteuse du fait de pertes en ligne inférieures aux réseaux à courant alternatif et d'absence d'incidence des capacités parasites du réseau sur de longues distances.

Cependant, dans de tels réseaux HVDC, notamment dans le cas de réseaux multipoints ou multinœuds, en cas de court-circuit sur l'une des lignes, le défaut se propage très rapidement dans tout le système et le courant de court-circuit peut atteindre plusieurs dizaines de kA en quelques millisecondes et dépasser le pouvoir de coupure des disjoncteurs HVDC qui est généralement limité à environ 15kA.

Il convient donc d'établir une stratégie d'une part de prévention et d'autre part de protection fiable et rapide permettant de détecter au plus tôt l'apparition d'un défaut, de le localiser et d'interrompre localement la ligne en défaut pour éviter toute propagation au reste du réseau et éviter également une mise hors tension d'une grande partie du réseau. Si on peut détecter de manière préventive l'apparition d'un défaut, on peut alors programmer des actions de maintenance à l'avance, comme par exemple le remplacement d'une partie du câble de transport électrique, et organiser de façon planifiée la distribution de l'énergie électrique pendant l'intervention de maintenance sans compromettre la distribution de l'énergie électrique du réseau dans son ensemble.

Un des aspects à traiter pour la maintenance préventive dans de tels réseaux de transport d'énergie électrique concerne la détection d'une altération des propriétés du câble de transport, notamment une altération de la gaine d'isolation autour de l'âme centrale conductrice.

En effet, les câbles de transport électrique peuvent être enfouis le long de leur parcours et être exposés à différents paramètres environnementaux. Par exemple enfoui sous une route, en été, le câble de transport peut être exposé à des températures élevées. Le câble peut aussi passer par exemple par des rivières, des champs, des lacs, la mer ou des forêts. On comprend donc aussi que différentes sections de câbles ne sont pas exposées aux mêmes paramètres environnementaux de sorte que l'altération du câble de transport d'énergie électrique n'est pas uniforme.

On connaît par exemple du document WO2012162486 un système de surveillance d'un câble de transport d'énergie électrique. Toutefois, le système proposé ne semble pas assez précis, notamment afin de pouvoir programmer par exemple des actions de maintenance préventive.

La présente invention a pour objet de proposer un procédé et un dispositif de surveillance d'un système de transport d'énergie électrique qui puissent être plus précis dans la détermination d'une alerte.

A cet effet, la présente invention concerne un procédé de surveillance d'un système de transport d'énergie électrique pour un réseau de transport d'énergie électrique à courant continu comprenant un câble de transport d'énergie électrique, avec :

- une âme centrale conductrice électriquement configurée pour transmettre un courant électrique,
- une enveloppe isolante électriquement disposée autour de l'âme centrale,
- un écran métallique disposé autour de l'enveloppe isolante,
- des connexions de mise à la terre de l'écran métallique, un segment de mesure étant défini entre deux connexions de mise à la terre successives,

le procédé comprenant les étapes suivantes :

- détermination le long d'un segment de mesure d'au moins un profil d'un paramètre de température,
- détermination d'un courant de fuite théorique entre les connexions de mise à la terre du segment de mesure en tenant compte des profils de paramètres de température et du courant et de la tension de charge,
- mesure du courant de fuite entre les connexions de mise à la terre du segment de mesure,
- génération d'une alerte si la différence entre le courant de fuite théorique et le courant de fuite mesuré dépasse un seuil prédéterminé.

Le procédé peut présenter un ou plusieurs des aspects suivants pris seuls ou en combinaison.

Selon un aspect, on détermine par exemple au moins certains profils de paramètres de température, notamment la température externe du câble de transport d'énergie électrique, par des mesures par un système optique à fibre.

Selon un autre aspect, on détermine par exemple au moins certains profils de paramètres de température, notamment la température ambiante hors sol, par des mesures par capteurs de température disposés le long d'un segment de mesure et/ou par des données météorologiques le long d'un segment de mesure.

La détermination par calcul d'un courant de fuite théorique comprend notamment les étapes suivantes :

- classification par plusieurs plages de température du câble de transport d'énergie d'un segment de mesure en sections, une plage de température ayant une étendue inférieure ou égale à 10°C, notamment inférieure ou égale à 5°C,
- détermination par calcul de courants de fuite théoriques partiels par sections,
- addition des courants de fuite théoriques partiels pour obtenir le courant de fuite théorique d'un segment de mesure.

L'étendue de la plage de température au sein d'une même section est en particulier inférieure à 2°C, notamment à 1,5°C.

L'étape de détermination par calcul d'un courant de fuite théorique partiel par sections est notamment réalisée en une seule fois pour des sections d'une même classe à l'issue de la classification.

Un paramètre de température est la température externe du câble de transport d'énergie électrique ou la température mesurée à proximité du câble de transport d'énergie électrique ou la température ambiante au sol, ceci le long du câble de transport d'énergie d'un segment de mesure.

Lors de la détermination par calcul d'un courant de fuite théorique dans un segment de mesure, il est par exemple tenu compte d'au moins un paramètre environnemental pris dans le groupe suivant:

- le profil de profondeur d'enfouissement du câble de transport électrique,
- le profil de la résistance thermique du sol entourant le câble de transport électrique,
- le profil de la chaleur spécifique du sol entourant le câble de transport électrique.

Lors de la détermination par calcul d'un courant de fuite théorique d'un segment de mesure, il est notamment tenu compte d'un modèle de vieillissement, notamment des propriétés thermiques et/ou électriques de l'enveloppe isolante du câble de transport d'énergie.

L'invention concerne également un dispositif de surveillance d'un système de transport d'énergie électrique pour un réseau de transport d'énergie électrique à courant continu comprenant un câble de transport d'énergie électrique, avec :

- une âme centrale conductrice électriquement configurée pour transmettre un courant électrique,
- une enveloppe isolante électriquement disposée autour de l'âme centrale,
- un écran métallique disposé autour de l'enveloppe isolante,
- des connexions de mise à la terre de l'écran métallique, un segment de mesure étant défini entre deux connexions de mise à la terre successives,

le dispositif comprenant une ou plusieurs unités fonctionnelles configurées pour :

- déterminer le long d'un segment de mesure au moins un profil d'un paramètre de température,
- déterminer un courant de fuite théorique entre les connexions de mise à la terre du segment de mesure en tenant compte des profils de paramètres de température et du courant et de la tension de charge,
- mesurer le courant de fuite entre les connexions de mise à la terre du segment de mesure,
- générer d'une alerte si la différence entre le courant de fuite théorique et le courant de fuite mesuré dépasse un seuil prédéterminé.

Le dispositif peut présenter un ou plusieurs des aspects suivants pris seuls ou en combinaison.

Au moins une unité fonctionnelle est par exemple configurée pour déterminer au moins certains profils de paramètres de température, notamment la température externe du câble de transport d'énergie électrique, par des mesures par un système optique à fibre.

Une unité fonctionnelle est notamment configurée pour déterminer au moins certains profils de paramètres de température, notamment la température ambiante hors sol, par des mesures par capteurs de température et/ou par des données météorologiques.

Au moins une unité fonctionnelle est par exemple configurée pour :

- réaliser une classification par plusieurs plages de température du câble de transport d'énergie d'un segment de mesure en sections, une plage de température ayant une étendue inférieure ou égale à 5°C,
- déterminer des courants de fuite théoriques partiels par sections,
- additionner des courants de fuite théoriques partiels pour obtenir le courant de fuite théorique d'un segment de mesure.

L'étendue de la plage de température au sein d'une même section est par exemple inférieure à 2°C, notamment à 1,5°C.

Un paramètre de température est notamment la température externe du câble de transport d'énergie électrique ou la température ambiante au sol, ceci le long du câble de transport d'énergie d'un segment de mesure.

Au moins une unité fonctionnelle est notamment configurée pour tenir compte d'au moins un paramètre environnemental pris dans le groupe suivant lors de la détermination par calcul d'un courant de fuite théorique dans un segment de mesure:

- le profil de profondeur d'enfouissement du câble de transport électrique,
- le profil de la résistance thermique du sol entourant le câble de transport électrique,
- le profil de la chaleur spécifique du sol entourant le câble de transport électrique.

Au moins une unité fonctionnelle est par exemple configurée pour tenir compte d'un modèle de vieillissement, notamment des propriétés thermiques et/ou électriques de l'enveloppe isolante du câble de transport d'énergie lors de la détermination par calcul d'un courant de fuite théorique dans un segment de mesure.

D'autres caractéristiques et avantages de l'invention ressortiront de la description suivante, donnée à titre d'exemple et sans caractère limitatif, en regard des dessins annexés sur lesquels :

[Fig 1] est une vue schématique en perspective d'un exemple simplifié d'un câble de transport d'énergie électrique,

[Fig 2] est une vue schématique d'un exemple d'un système de transport d'énergie électrique,

[Fig 3] est un exemple d'un organigramme du procédé selon l'invention,

[Fig 4] montre une vue schématique d'un segment de mesure ;

[Fig 5] montre de façon schématique un exemple d'un dispositif selon l'invention.

Sur toutes les figures, les éléments ayant des fonctions identiques portent les mêmes numéros de référence.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées ou interchangées pour fournir d'autres réalisations.

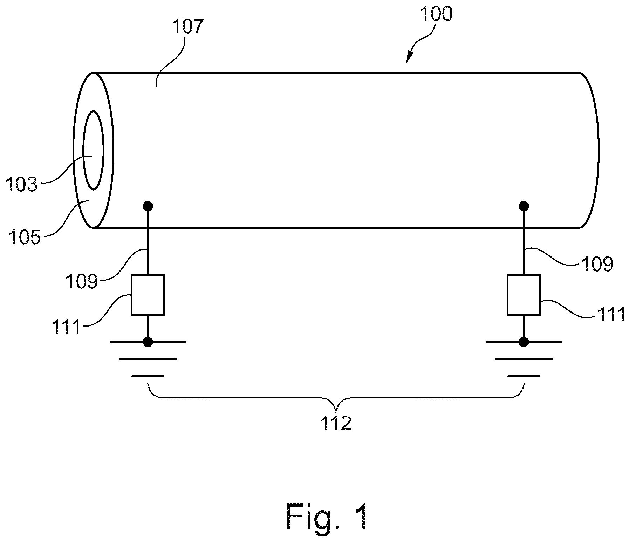

La figure 1 montre une vue schématique et simplifié, partiellement en coupe d'un câble de transport d'énergie électrique 100.

Un tel câble de transport d'énergie électrique 100 comprend typiquement une âme centrale 103 conductrice électriquement, par exemple en cuivre, et configurée pour transmettre un courant électrique, notamment un courant continu.

L'âme centrale 103 est entourée d'une enveloppe isolante électriquement 105 par exemple en polyéthylène réticulé.

Autour de l'enveloppe isolante est disposé un écran métallique 107.

Bien entendu autour de l'écran métallique 107 peuvent être disposés d'autres couches ou des fibres non représentées ayant par exemple des fonctions mécaniques (par exemple des armatures) ou des fonctions de service (par exemple des fibres optiques pour la transmission de signaux de service ou pour des mesures). En particulier, des couches semi-conductrices non représentées peuvent en outre être présentes d'une part entre l'âme centrale 103 conductrice et l'enveloppe isolante électriquement 105 et d'autre part entre l'enveloppe isolante électriquement 105 et l'écran métallique.

A des intervalles prédéfinis et pour des raisons de sécurité, l'écran métallique 107 est relié à la terre par une connexion de mise à la terre 109.

Sur la figure 1, les connexions de mise à la terre 109 ont été représentées schématiquement comme directement connectées sur l'écran métallique 107 d'un câble 100.

Mais plus typiquement, ces connexions de mise à la terre 109 sont généralement opérées à des localisations plus opportunes. En effet, ces câbles 100 de transport électriques ont une certaine longueur (par exemple une ou plusieurs centaine à quelques km) et pour couvrir une distance plus grande (par exemple une centaine de km ou plus), il faut raccorder plusieurs tronçons ou longueurs de câbles 100 les uns aux autres, notamment via de jonctions. Ces jonctions peuvent disposer d'une ou plusieurs mise(s) à la terre, mais cela n'est pas obligatoire pour chaque jonction.

Ainsi, ces connexions mise à la terre de 109 sont par exemple disposées en extrémité d'un tronçon ou d'une longueur de câble de transport d'énergie électrique 100 à l'endroit où il faut le raccorder au suivant tronçon/ la suivante longueur via une jonction ou encore quand l'extrémité du câble de transport d'énergie électrique 100 est raccordée par exemple à un autre équipement comme par exemple une station convertisseur.

Cette connexion de mise à la terre 109 peut être faite via une faible impédance (un simple raccord électrique de mise à la terre) ou via une impédance variable par exemple par le biais d'un dispositif de limiteur de surtension.

Dans la connexion de mise à la terre 109 est par exemple disposé un capteur 111 de mesure du courant de fuite, par exemple un capteur de mesure de courant continu.

Comme cela sera détaillé plus loin, deux connexions de mise à la terre successives 109 vont définir un segment de mesure 112, en particulier pour mesurer le courant de fuite qui dépend en particulier des propriétés à l'instant t de l'enveloppe isolante électriquement 105 et des paramètres environnementaux, notamment de la température. En effet, les propriétés de l'enveloppe isolante 105 peuvent varier en fonction du temps, par exemple à cause d'un vieillissement du matériau subi à cause des changements de température.

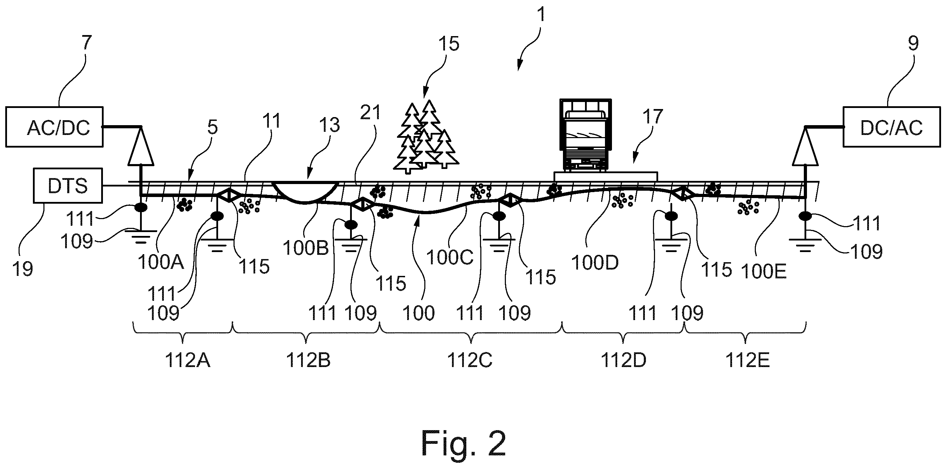

Sur la figure 2 est montré schématiquement un système 1 de transport d'énergie électrique à courant continu. Il peut s'agir d'un système 1 de transport d'énergie électrique à courant continu basse, moyenne ou haute tension.

Ce système 1 comporte notamment le câble de transport d'énergie électrique 100 qui est par exemple enfoui dans le sol 5 le long de son parcours entre deux stations convertisseurs 7 et 9. A titre d'exemple, il s'agit donc ici d'un système point à point.

Les stations convertisseurs 7 et 9 sont représentées sur la figure 1 comme convertisseurs AC/DC (courant alternatif AC - courant continu DC) pour la station 7 et DC/AC (courant continu DC - courant alternatif AC) pour la station 9.

En variante, on peut aussi prévoir, en fonction des besoins, par exemple des stations DC/DC comme élévateur ou abaisseur de tension entre deux réseaux ou deux câbles de transport d'énergie électrique 100 ne fonctionnant pas à la même tension. On peut par exemple citer une liaison entre un réseau haute tension à courant continu et un réseau basse tension à courant continu.

A une des extrémités des stations convertisseurs 7 ou 9, une installation (non représentée) de production d'énergie électrique peut être connectée, comme une installation de production d'énergie renouvelable (des panneaux photovoltaïques, une usine hydroélectrique, des éoliennes etc.).

A l'autre des extrémités des stations convertisseurs 7 ou 9 est par exemple connecté un réseau traditionnel de distribution d'énergie électrique en courant alternatif pour acheminer l'énergie électrique jusqu'aux consommateurs finaux.

Bien entendu, la figure 1 ne présente qu'un exemple simplifié et le système 1 de transport d'énergie électrique peut comprendre plusieurs câbles de transport d'énergie électrique 100, qui peuvent être connectés entre eux par exemple en réseau selon une topographie de réseau souhaité (en anneau, en étoile ou une combinaison de ces deux topographies, voire une structure de réseau plus complexe).

A la figure 2, le câble de transport d'énergie électrique 100 est enfoui, le niveau du sol 11 étant représenté par un trait. Lors de l'enfouissement du câble de transport d'énergie électrique 100, le parcours et la topologie du terrain sont relevés et consignés, par exemple dans une base de données. Ainsi, la base de données comprend une multitude de positions géographiques correspondant à la position exacte du câble de transport d'énergie électrique 100, et pour chacune de ces positions géographiques sa profondeur d'enfouissement, la nature du sol avec ses caractéristiques (par exemple la résistance thermique et/ou la chaleur spécifique) et d'autres particularités (passage sous une route ou dans une rivière).

Comme on le voit schématiquement sur la figure 2, la profondeur de l'enfouissement du câble de transport d'énergie électrique 100 varie sur son parcours. De plus, le câble 100 passe par exemple dans une rivière 13, sous une forêt 15 ou sous une route 17.

En conséquence, même si on suppose par exemple que la température ambiante de l'air est constante tout au long du parcours du câble 100, il n'est pas de même de la température autour du câble de transport d'énergie électrique 100 qui peut être par exemple plus faible que la température ambiante de l'air lors d'un passage en rivière, lorsque la profondeur d'enfouissement est plus grande ou lors d'un passage abrité par exemple dans une forêt. Cette température du câble 100 de transport d'énergie électrique peut être plus élevée par exemple lors d'un passage sous une route goudronnée 17 exposée au soleil.

Pour certains réseaux, le câble 100 évolue par exemple le long d'infrastructures routières ou ferroviaires existantes qui relient des agglomérations et peut être sujet à des échauffements importants par temps ensoleillé.

Le câble de transport électrique 100 peut par exemple être formé par plusieurs tronçons ou longueurs de câble 100 raccordés les uns aux autres.

Sur la figure 2, à titre d'exemple sont représentés cinq tronçons ou longueur de câble 100A-E.

Ces tronçons 100A-E sont reliés par des jonctions 115 qui sont ici des jonctions avec des connexions 109 de mise à la terre présentant des capteurs 111 du courant de fuite. Bien entendu, on peut prévoir dans chacun des tronçons 100A-E des jonctions supplémentaires par exemple sans connexion de mise à la terre.

Donc entre deux connexions 109 de mise à la terre successives, on peut définir un segment de mesure 112, dans le présent cas cinq segments de mesure 112A-E.

En outre, le système 1 est équipé d'un système 19 de mesure de température DTS (DTS pour « distributed temperature sensing system » en anglais). Il s'agit par exemple d'un des systèmes décrit dans l'article « Distributed Temperature Sensing: Review of Technology and Applications" IEEE Sensors Journal ( Volume: 12, Issue: 5 , May 2012).

En pratique un système 19 de mesure de température DTS comprend une ou plusieurs fibres optiques 21 qui peuvent être intégrés dans l'armature du câble 100 de transport d'énergie électrique et qui permettent de dresser le profil de température le long du câble avec une précision d'environ 1°C et une résolution spatiale d'environ 1m sur la distance.

En variante, comme représenté sur la figure 2, la fibre du système 19 de mesure de température DTS n'est pas intégrée dans l'armature du câble 100, mais est séparée de celui-ci. Dans ce cas, les fibres optiques 21 sont disposées à proximité du câble 100 de transport d'énergie électrique. En choisissant une installation séparée, on peut plus facilement opérer un remplacement des fibres optiques 21 en cas de défaillance.

De façon alternative, pour déterminer le profil de température, on peut aussi disposer des capteurs de température le long du câble 100 de transport d'énergie électrique. Il peut s'agir de sondes, notamment de sondes infrarouges.

Selon encore une autre alternative, on peut déterminer le profil de température à partir de données météorologiques (température de l'air, température du sol), des données concernant l'enfouissement du câble 100 et une modélisation thermodynamique qui permet de calculer à partir de la température ambiante ou la température du sol la température au niveau du câble 100. Dans ce cas, on prend également en compte la charge (courant et tension) à laquelle le câble de transport 100 est soumis et qui contribue aussi à un échauffement de l'enveloppe isolante 105 et à son vieillissement.

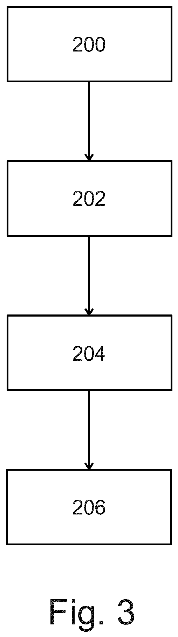

La figure 3 montre de façon schématique et simplifié des étapes du procédé de l'invention. Certaines étapes peuvent se dérouler en parallèle ou dans un autre ordre que celui montré sur la figure 3.

Selon une étape 200, le long d'au moins un segment de mesure 112, voir le long de tous les segments de mesures 112A-E, au moins un profil d'un paramètre de température est déterminé.

Comme évoqué ci-dessus, on peut dresser le profil de température à l'aide d'un système de mesure de température DTS 19 grâce à une technologie de fibre optique intégrée dans l'armature du câble 100 de transport d'énergie électrique. Ainsi, on dispose par exemple pour toutes les positions géographiques enregistrées dans la base de données et correspondant à la localisation du câble 100 de transport d'énergie électrique d'une valeur de température mesurée à proximité de l'écran métallique 107 du câble 100.

Le courant de fuite est une manifestation des charges électriques traversant l'enveloppe isolante 105 (le diélectrique) du câble de transport d'énergie électrique 100. Ce courant de fuite est en particulier fonction de la température l'âme centrale conductrice 103 du câble 100 dû à l'effet Joule, du gradient de température entre l'âme conductrice 103 et l'écran métallique 107, de la tension appliquée et de l'état diélectrique éventuellement variable dans le temps de l'enveloppe isolante 105.

La température ainsi mesurée par le système de mesure de température DTS 19 devrait être quasiment celle de l'écran métallique 107.

En connaissant en particulier la tension appliquée au câble de transport électrique 100, le courant de charge et le profil de température, selon une étape 202, on détermine par calcul un courant de fuite théorique I_leak-theo entre les connexions de mise à la terre 109 du segment de mesure 112.

Cette détermination par calcul d'un courant de fuite théorique I_leak-theo peut être réalisée au moins selon deux modes de réalisations.

Selon un premier mode de réalisation, on calcule I_leak-theo sur la base des formules de physique applicables. Il s'agit donc d'une simulation entièrement numérique.

Selon un deuxième mode de réalisation, la détermination par calcul d'un courant de fuite théorique I_leak-theo peut prendre appui sur un retour d'expérience en particulier par des mesures de courant de fuite sur une durée prédéterminée, notamment une durée d'apprentissage qui peut par exemple atteindre une année d'exploitation du système de transport d'énergie électrique 1. La détermination par calcul d'un courant de fuite théorique I_leak-theo entre les deux jonctions mises à la terre peut consister à faire appel à une base de donnée contenant les mesures réalisées lors d'une première année d'exploitation pour chaque segment et en cherchant des mesures qui ont été faites avec des profils de paramètre de température et du courant de charge similaires et en appliquant par exemple des facteurs de correction.

Bien entendu, on peut aussi envisager d'autres modes de réalisation, en particulier une combinaison des premier et deuxième modes de réalisation décrits ci-dessus. Ainsi, on peut prévoir que la durée d'apprentissage soit réduite, par exemple à un ou deux mois d'exploitation, par exemple au printemps ou à l'automne ou encore un mois au printemps et un mois à l'automne et qu'ensuite, on puisse calculer I_leak-theo par des extrapolations numériques pour tenir compte notamment des profils de température durant l'été ou de l'hiver.

Selon une étape 204 (qui peut aussi précéder l'étape 200 ou 202), on mesure le courant de fuite I_leak-mes entre les connexions 109 de mise à la terre du segment de mesure 112 considéré.

Puis selon une étape 206, on génère une alerte si la différence entre l'amplitude du courant de fuite théorique I_leak-theo et l'amplitude du courant de fuite mesuré I_leak-mes dépasse un seuil prédéterminé, par exemple si cette différence est supérieure à 5-20% I_leak-mes.

On va détailler par la suite comment notamment l'étape 202 du procédé de la figure 3 peut être optimisée d'avantage.

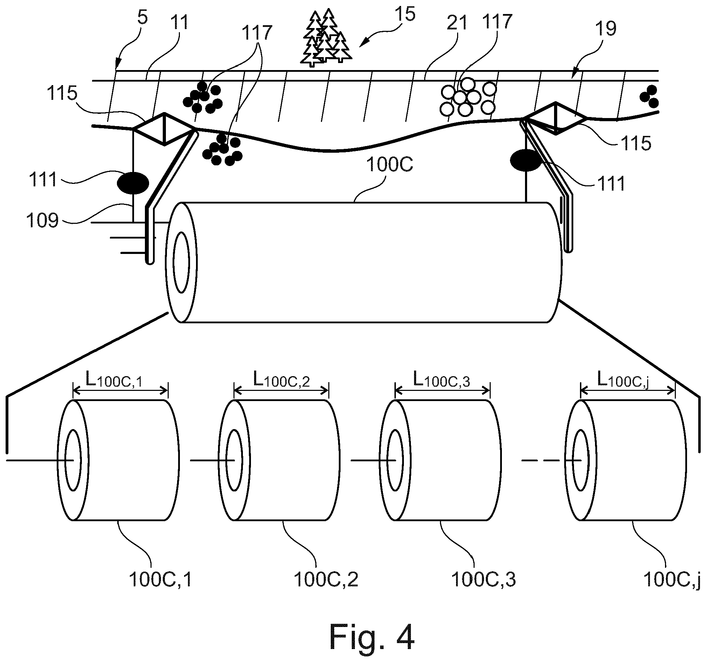

Pour cela considérons la figure 4 montrant à titre d'exemple le segment de mesure 112C.

Chaque segment de mesure 112 (ici 112C) peut être sous-divisé en j sections (j étant un nombre naturel) et on peut démontrer que le courant de fuite I_leak_112C est la somme des courants de fuite des j sections. Plus généralement

$$I_{leak_i}(t) = \sum_{n=1}^{j} I_{leak\_i,j}(t)$$

où i est la référence du segment de mesure, ici 112C et j le nombre de sections sous-divisant le segment de mesure i.

Pour optimiser le procédé de la figure 3, la sous-division en j sections va se faire par une classification des sections par plusieurs plages de température du câble de transport d'énergie, une plage de température ayant une étendue inférieure ou égale à 5°C, plus spécifiquement inférieure ou égale à 2°C et notamment inférieur ou égal à 1,5°C.

Par exemple le segment de mesure 112C est divisé en j sections, chaque section appartenant par exemple à une des plages de température d'une étendue de 2°C, en particulier la plage de T= 30°C à T<32°C, T=32°C à T<34°C, T=34°C à T<36°C, T=36°C à T<38°C, T=38°C à T<40°C,....T=48°C à T<50°C.

La longueur de chaque section Li,j (dans le présent cas L_100C,1, L_100C,2, L_100C,3.... L_100C,j) peut être variable et dépend seulement du fait que la température se situe à l'intérieur d'une des plages prédéfinies.

Cette classification a pour but de faciliter et d'accélérer la détermination du courant de fuite théorique I_leak-theo.

En effet, comme déjà évoqué ci-dessus le courant de fuite est en particulier fonction de la température de l'âme centrale conductrice 103 du câble 100 dû à l'effet Joule, du gradient de température entre l'âme conductrice 103 et l'écran métallique 107, de la tension appliquée et de l'état du diélectrique éventuellement variable dans le temps d'enveloppe isolante 105.

En conséquence, connaissant le courant de charge I_load et la tension de charge V_load appliqués au câble 100 de transport d'énergie électrique, et la résistance électrique dépendante de la température de l'âme centrale nommée R (T_ (c, 100C)), on peut déterminer la contribution de l'âme centrale 103 à l'élévation de température par effet Joule et en mesurant la température notamment à proximité de l'écran métallique 107 par le système de mesure de température DTS 19, on peut calculer le courant de fuite qui dépend du gradient de température d'une part et de l'état du diélectrique de l'enveloppe isolante 105 (en particulier aussi de son vieillissement) d'autre part.

A un instant t donné, le courant de charge I_load et la tension de charge V_load appliqués au câble 100 de transport d'énergie électrique peuvent être considéré comme constant le long du segment de mesure 112C.

Seule la température mesurée notamment à proximité de l'écran métallique 107 par le système de mesure de température DTS 19 varie notamment en fonction de l'environnement du câble comme cela a été décrit ci-dessus.

En effet, la profondeur à laquelle le câble de transport 100 et les jonctions 115 sont enfouis n'est pas constante et l'environnement du câble de transport 100 et des jonctions 115 varie le long du parcours du câble 100. La variation de l'enfouissement et aussi du remblai 117 entourant le câble induit un environnement thermique variable pour le câble 100 et les jonctions 115.

En divisant le segment de mesure i en sections appartenant à une même plage de température, on peut calculer les courants de fuite des sections j appartenant à la même plage ou classe de température en quasiment une seule opération de calcul, ce qui permet d'accélérer de façon importante la détermination du courant de fuite du segment de mesure en question. L'étape de détermination par calcul d'un courant de fuite théorique partiel par sections peut donc être réalisée en une seule fois pour des sections j d'une même classe à l'issue de la classification.

On peut ainsi déterminer par calcul de courants de fuite théoriques partiels par sections j, puis additionner des courants de fuite théoriques partiels pour obtenir le courant de fuite théorique d'un segment de mesure i.

Lors de la détermination par calcul d'un courant de fuite théorique dans un segment de mesure, il est tenu compte d'au moins un paramètre environnemental pris dans le groupe suivant:

- le profil de profondeur d'enfouissement du câble de transport électrique
- le profil de la résistance thermique du sol entourant le câble de transport électrique,
- le profil de la chaleur spécifique du sol entourant le câble de transport électrique.
- un modèle de vieillissement, notamment des propriétés thermiques et/ou électriques de l'enveloppe isolante du câble de transport d'énergie.

Ces paramètres environnementaux peuvent aussi servir pour affiner d'avantage la classification des sections j, c'est-à-dire les sections j d'une même classe ne se trouvent non seulement dans la même plage de température, mais aussi notamment dans une même plage de profondeur d'enfouissement.

Dans le cas où on ne dispose pas d'un système de mesure de température 19 DTS, mais seulement par exemple de données météorologiques (température de l'air, du sol, l'ensoleillement etc.), on peut modéliser la température à proximité du câble 100 en tenant compte des données d'enfouissement qui peuvent être stockées par exemple dans une base de données.

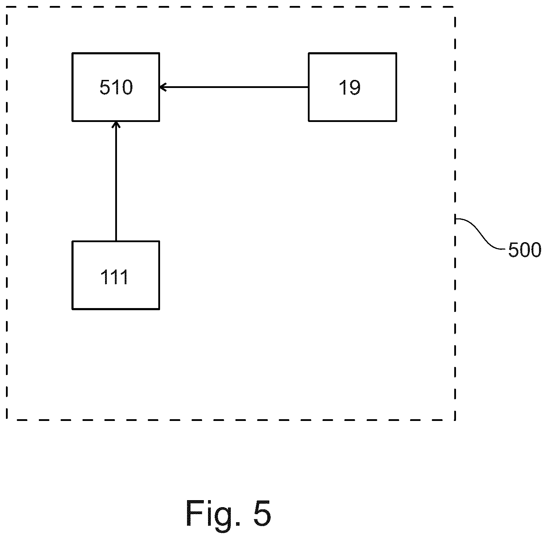

Le procédé illustré de façon exemplaire à la figure 3, peut être réalisé par un dispositif 500 de surveillance d'un système de transport d'énergie électrique pour un réseau 1 de transport d'énergie électrique à courant continu comme montré sur la figure 5.

Ce dispositif 500 comprend une ou plusieurs unités fonctionnelles configurées pour réaliser une ou plusieurs des étapes du procédé de la figure 3.

Selon un exemple de réalisation, le dispositif 500 comprend un système de mesure de température DTS 19 pour déterminer le long d'un segment de mesure au moins un profil d'un paramètre de température. D'autres systèmes par exemple des sondes ou capteurs de température à infrarouge peuvent être envisagés

Le dispositif 500 comprend de plus des capteurs 111 de mesure du courant de fuite, par exemple un capteur de mesure de courant continu disposé dans des connexions de mise à la terre 109.

Enfin, le dispositif 500 comprend par exemple une unité de calcul et de traitement 510, par exemple un ordinateur équipé d'un processeur, de mémoires vives et de mémoire mortes et chargé un programme informatique spécifique pour déterminer par calcul un courant de fuite théorique entre les connexions de mise à la terre d'un segment de mesure en tenant compte des profils de paramètres de température et du courant et de la tension de charge, et pour générer une alerte si la différence entre le courant de fuite théorique et le courant de fuite mesuré dépasse un seuil prédéterminé.

L'unité de calcul et de traitement 510 est par exemple aussi configurée pour :

- réaliser une classification par plusieurs plages de température du câble de transport d'énergie d'un segment de mesure en sections, une plage de température ayant une étendue inférieure ou égale à 5°C, notamment inférieure ou égale à 2°C, et plus spécifiquement inférieure ou égale à 1,5°C,
- déterminer par calcul de courants de fuite théoriques partiels par sections,
- additionner des courants de fuite théoriques partiels pour obtenir le courant de fuite théorique d'un segment de mesure.

Le paramètre de température peut être la température externe du câble de transport 100 ou la température ambiante au sol, ceci le long du câble de transport d'énergie d'un segment de mesure. Dans ce dernier cas, on modélise les transferts thermiques pour remonter à la température du câble de transport au niveau de l'écran métallique 107.

L'unité de calcul et de traitement 510 est par exemple aussi configurée pour tenir compte d'au moins un paramètre environnemental pris dans le groupe suivant lors de la détermination par calcul d'un courant de fuite théorique dans un segment de mesure:

- le profil de profondeur d'enfouissement du câble de transport électrique,
- le profil de la résistance thermique du sol entourant le câble de transport électrique,
- le profil de la chaleur spécifique du sol entourant le câble de transport électrique,
- d'un modèle de vieillissement, notamment des propriétés thermiques et/ou électriques de l'enveloppe isolante du câble de transport d'énergie lors de la détermination par calcul d'un courant de fuite théorique dans un segment de mesure.

Enfin, l'unité de calcul et de traitement 510 peut mémoriser et puis tenir compte de l'historique de certains paramètres lors de l'exploitation (historique du courant nominal lors de l'exploitation ou de la température du câble de transport électrique) afin de les utiliser pour déterminer encore plus finement des écarts entre le courant de fuite théorique (I_leak-theo) et le courant de fuite mesuré (I_leak-mes).

On comprend donc que le procédé et le dispositif de surveillance selon l'invention permettent des interventions de maintenance préventives avant l'apparition d'un défaut sur l'enveloppe isolante 107 pouvant causer un court-circuit.

**Revendications**

1. Procédé de surveillance d'un système (1) de transport d'énergie électrique pour un réseau de transport d'énergie électrique à courant continu comprenant un câble de transport d'énergie électrique (100), avec :

    - une âme centrale (103) conductrice électriquement configurée pour transmettre un courant électrique,
    - une enveloppe isolante (105) électriquement disposée autour de l'âme centrale (103),
    - un écran métallique (107) disposé autour de l'enveloppe isolante (105),
    - des connexions de mise à la terre de l'écran métallique (107), un segment de mesure (112A, 112B, 112C, 112D, 112E) étant défini entre deux connexions de mise à la terre (109) successives,

    le procédé comprenant les étapes suivantes :

    - détermination le long d'un segment de mesure (112C) d'au moins un profil d'un paramètre de température,
    - détermination d'un courant de fuite théorique (I_leak-theo) entre les connexions (109) de mise à la terre du segment de mesure (112C) en tenant compte des profils de paramètres de température et du courant et de la tension de charge,
    - mesure du courant de fuite (I_leak-mes) entre les connexions (109) de mise à la terre du segment de mesure (112C),
    - génération d'une alerte si la différence entre le courant de fuite théorique (I_leak-theo) et le courant de fuite mesuré (I_leak-mes) dépasse un seuil prédéterminé.

2. Procédé de surveillance selon la revendication 1, dans lequel on détermine au moins certains profils de paramètres de température, notamment la température externe du câble (100) de transport d'énergie électrique, par des mesures par un système optique à fibre (19).

3. Procédé de surveillance selon la revendication 1 ou 2, dans lequel on détermine au moins certains profils de paramètres de température, notamment la température ambiante hors sol, par des mesures par capteurs de température disposés le long d'un segment de mesure et/ou par des données météorologiques le long d'un segment de mesure.

4. Procédé de surveillance selon l'une quelconque des revendications 1 à 3, dans lequel la détermination par calcul d'un courant de fuite théorique (I_leak_theo) comprend les étapes suivantes :

- classification par plusieurs plages de température du câble (100) de transport d'énergie d'un segment de mesure (112) en sections (j), une plage de température ayant une étendue inférieure ou égale à 10°C, notamment inférieure ou égale à 5°C,
- détermination par calcul de courants de fuite théoriques partiels par sections (j),
- addition des courants de fuite théoriques partiels pour obtenir le courant de fuite théorique (I_leak_theo) d'un segment de mesure (112C).

5. Procédé de surveillance selon la revendication 4, dans lequel l'étendue de la plage de température au sein d'une même section est inférieure à 2°C, notamment à 1,5°C.

6. Procédé de surveillance selon l'une quelconque des revendications 4 ou 5, dans lequel l'étape de détermination par calcul d'un courant de fuite théorique partiel par sections est réalisée en une seule fois pour des sections d'une même classe à l'issue de la classification.

7. Procédé de surveillance selon l'une quelconque des revendications 1 à 6, dans lequel un paramètre de température est la température externe du câble de transport d'énergie électrique (100) ou la température mesurée à proximité du câble de transport d'énergie électrique (100) ou la température ambiante au sol, ceci le long du câble de transport d'énergie (100) d'un segment de mesure (112C).

8. Procédé de surveillance selon l'une quelconque des revendications 1 à 7, dans lequel lors de la détermination par calcul d'un courant de fuite théorique (I_leak-theo) dans un segment de mesure (112C), il est tenu compte d'au moins un paramètre environnemental pris dans le groupe suivant:

- le profil de profondeur d'enfouissement du câble de transport électrique,
- le profil de la résistance thermique du sol entourant le câble de transport électrique,
- le profil de la chaleur spécifique du sol entourant le câble de transport électrique.

9. Procédé de surveillance selon l'une quelconque des revendications 1 à 8, dans lequel lors de la détermination par calcul d'un courant de fuite théorique (I_leak-theo) d'un segment de mesure (112C), il est tenu compte d'un modèle de vieillissement, notamment des propriétés thermiques et/ou électriques de l'enveloppe isolante du câble de transport d'énergie.

10. Dispositif (500) de surveillance d'un système (1) de transport d'énergie électrique pour un réseau de transport d'énergie électrique à courant continu comprenant un câble de transport d'énergie électrique (100), avec :

- une âme centrale (103) conductrice électriquement configurée pour transmettre un courant électrique,
- une enveloppe isolante (105) électriquement disposée autour de l'âme centrale (103),
- un écran métallique (107) disposé autour de l'enveloppe isolante (105),
- des connexions de mise à la terre de l'écran métallique (107), un segment de mesure (112A-E) étant défini entre deux connexions (109) de mise à la terre successives,

le dispositif (500) comprenant une ou plusieurs unités fonctionnelles configurées pour :

- déterminer le long d'un segment de mesure (112C) au moins un profil d'un paramètre de température,
- déterminer un courant de fuite théorique (I_leak-theo) entre les connexions (109) de mise à la terre du segment de mesure (112C) en tenant compte des profils de paramètres de température et du courant et de la tension de charge,
- mesurer le courant de fuite (I_leak-mes) entre les connexions de mise à la terre du segment de mesure,
- générer d'une alerte si la différence entre le courant de fuite théorique (I_leak-theo) et le courant de fuite mesuré (I_leak-mes) dépasse un seuil prédéterminé.

11. Dispositif de surveillance selon la revendication 10, dans lequel au moins une unité fonctionnelle est configurée pour déterminer au moins certains profils de paramètres de température, notamment la température externe du câble de transport d'énergie électrique (100), par des mesures par un système optique à fibre(19).

12. Dispositif de surveillance selon la revendication 10 ou 11, dans lequel au moins une unité fonctionnelle est configurée pour déterminer au moins certains profils de paramètres de température, notamment la température ambiante hors sol, par des mesures par capteurs de température et/ou par des données météorologiques.

13. Dispositif de surveillance selon l'une quelconque des revendications 10 à 12, dans lequel au moins une unité fonctionnelle est configurée pour :

- réaliser une classification par plusieurs plages de température du câble de transport d'énergie (100) d'un segment de mesure en sections (j), une plage de température ayant une étendue inférieure ou égale à 5°C,
- déterminer des courants de fuite théoriques partiels par sections,
- additionner des courants de fuite théoriques partiels pour obtenir le courant de fuite théorique (I_leak-theo) d'un segment de mesure (112C).

14. Dispositif de surveillance selon la revendication 13, dans lequel l'étendue de la plage de température au sein d'une même section est inférieure à 2°C, notamment à 1,5°C.

15. Dispositif de surveillance selon l'une quelconque des revendications 10 à 14, dans lequel un paramètre de température est la température externe du câble de transport d'énergie électrique (100) ou la température ambiante au sol, ceci le long du câble de transport d'énergie (100) d'un segment de mesure.

16. Dispositif de surveillance selon l'une quelconque des revendications 10 à 15, dans lequel au moins une unité fonctionnelle est configurée pour tenir compte d'au moins un paramètre environnemental pris dans le groupe suivant lors de la détermination par calcul d'un courant de fuite théorique (I_leak-theo) dans un segment de mesure (112C):

- le profil de profondeur d'enfouissement du câble de transport électrique,
- le profil de la résistance thermique du sol entourant le câble de transport électrique,
- le profil de la chaleur spécifique du sol entourant le câble de transport électrique.

17. Dispositif de surveillance selon l'une quelconque des revendications 10 à 16, dans lequel dans lequel au moins une unité fonctionnelle est configurée pour tenir compte d'un modèle de vieillissement, notamment des propriétés thermiques et/ou électriques de l'enveloppe isolante du câble de transport d'énergie lors de la détermination par calcul d'un courant de fuite théorique (I_leak_theo) dans un segment de mesure (112C).

**Patentansprüche**

1. Verfahren zum Überwachen eines elektrischen Energietransportsystems (1) für ein Gleichstrom-Transportnetz, das ein elektrisches Energietransportkabel (100) umfasst, mit:

- einer zentralen elektrisch leitenden Seele (103), die zum Übertragen eines elektrischen Stroms konfiguriert ist,
- einen isolierenden Mantel (105), der elektrisch um die zentrale Seele (103) angeordnet ist,
- einen Metallschirm (107), der um den isolierenden Mantel (105) angeordnet ist,
- Erdungsanschlüsse des Metallschirms (107), wobei zwischen zwei aufeinanderfolgenden Erdungsanschlüssen (109) ein Messsegment (112 A, 112B, 112C, 112D, 112E) definiert ist,

wobei das Verfahren die folgenden Schritte umfasst:

- Bestimmung entlang eines Messsegments (112C) mindestens eines Profils eines Temperaturparameters,
- Bestimmung eines theoretischen Leckstroms (I_leak-theo) zwischen den Erdungsanschlüssen (109) des Messsegments (112C) unter Berücksichtigung der Profile von Temperaturparametern und des Stroms und der Ladespannung,
- Messung des Leckstroms (I_leak-mes) zwischen den Erdungsanschlüssen (109) des Messsegments (112C),
- Erzeugung einer Warnung, wenn die Differenz zwischen dem theoretischen Leckstrom (I_leak-theo) und dem gemessenen Leckstrom (I_leak-mes) einen vorbestimmten Schwellenwert überschreitet.

2. Überwachungsverfahren nach Anspruch 1, wobei mindestens bestimmte Profile von Temperaturparametern, insbesondere die Außentemperatur des elektrischen Energietransportkabels (100), durch Messungen durch ein faseroptisches System (19) bestimmt werden.

3. Überwachungsverfahren nach Anspruch 1 oder 2, wobei mindestens bestimmte Temperaturparametern, insbesondere die oberirdische Umgebungstemperatur, durch Messungen durch Temperatursensoren, die entlang eines Messsegments angeordnet sind, und/oder durch Wetterdaten entlang eines Messsegments bestimmt werden.

4. Überwachungsverfahren nach einem der Ansprüche 1 bis 3, wobei die Bestimmung durch Berechnung eines theoretischen Leckstroms (I_leak_theo) die folgenden Schritte umfasst:

- Klassifizierung durch mehrere Temperaturbereiche des elektrischen Energietransportkabels (100) eines Messsegments (112) in Teilabschnitte (j), wobei ein Temperaturbereich ein Ausmaß kleiner oder gleich 10 °C, insbesondere kleiner oder gleich 5 °C aufweist,
- Bestimmung partieller theoretischer Leckströme pro Teilabschnitt (j),
- Addition der partiellen theoretischen Teilleckströme, um den theoretischen Leckstrom (I_leak_theo) eines Messsegments (112C) zu erhalten.

5. Überwachungsverfahren nach Anspruch 4, wobei die Ausdehnung des Temperaturbereichs innerhalb desselben Teilabschnitts geringer als 2 °C, insbesondere 1,5 °C, ist.

6. Überwachungsverfahren nach einem der Ansprüche 4 oder 5, wobei der Schritt der Bestimmung durch Berechnung eines partiellen theoretischen Leckstroms nach Teilabschnitten auf einmal für Teilabschnitte derselben Klasse nach Abschluss der Klassifizierung durchgeführt wird.

7. Überwachungsverfahren nach einem der Ansprüche 1 bis 6, wobei ein Temperaturparameter die Außentemperatur des elektrischen Energietransportkabels (100) oder die in der Nähe des elektrischen Energietransportkabels (100) gemessene Temperatur oder die Umgebungstemperatur am Boden entlang des Energietransportkabels (100) eines Messsegments (112C) ist.

8. Überwachungsverfahren nach einem der Ansprüche 1 bis 7, wobei bei der Bestimmung durch Berechnung eines theoretischen Leckstroms (I_leak-theo) in einem Messsegment (112C) mindestens ein Umgebungsparameter aus der folgenden Gruppe berücksichtigt wird:

- das Einbettungstiefenprofil des elektrischen Transportkabels,
- das Profil des thermischen Widerstands des Bodens, der das elektrische Transportkabel umgibt,
- das spezifische Wärmeprofil des Bodens, der das elektrische Transportkabel umgibt.

9. Überwachungsverfahren nach einem der Ansprüche 1 bis 8, wobei bei der Bestimmung durch Berechnung eines theoretischen Leckstroms (I_leak-theo) eines Messsegments (112C) ein Alterungsmodell, insbesondere die thermischen und/oder elektrischen Eigenschaften des isolierenden Mantels des Energietransportkabels berücksichtigt werden.

10. Vorrichtung (500) zur Überwachung eines elektrischen Energietransportsystems (1) für ein Gleichstrom-Transportnetz, die ein elektrisches Energietransportkabel (100) umfasst, mit:

- einer zentralen elektrisch leitenden Seele (103), die zum Übertragen eines elektrischen Stroms konfiguriert ist,
- einen isolierenden Mantel (105), der elektrisch um die zentrale Seele (103) angeordnet ist,
- einen Metallschirm (107), der um den isolierenden Mantel (105) angeordnet ist,
- Erdungsanschlüssen des Metallschirms (107), wobei zwischen zwei aufeinanderfolgenden Erdungsanschlüssen (109) ein Messsegment (112A-E) definiert ist,

der Vorrichtung (500), die eine oder mehrere Funktionseinheiten umfasst, die dazu konfiguriert sind:

- entlang eines Messsegments (112C) mindestens ein Profil eines Temperaturparameters zu bestimmen,
- einen theoretischen Leckstrom (I_leak-theo) zwischen den Erdungsanschlüssen (109) des Messsegments (112C) unter Berücksichtigung der Profile von Temperaturparametern und des Ladestroms und der Ladespannung zu bestimmen,
- den Leckstrom (I_leak-mes) zwischen den Erdungsanschlüssen des Messsegments zu messen,
- eine Warnung zu erzeugen, wenn die Differenz zwischen dem theoretischen Leckstrom (I_leak-theo) und dem gemessenen Leckstrom (I_leak-mes) einen vorbestimmten Schwellenwert überschreitet.

11. Überwachungsvorrichtung nach Anspruch 10, wobei mindestens eine Funktionseinheit dazu konfiguriert ist, mindestens bestimmte Profile von Temperaturparametern, insbesondere die Außentemperatur des elektrischen Energietransportkabels (100), durch Messungen durch ein faseroptisches System (19) zu bestimmen.

12. Überwachungsvorrichtung nach Anspruch 10 oder 11, wobei mindestens eine Funktionseinheit dazu konfiguriert ist, mindestens bestimmte Temperaturparametern, insbesondere die oberirdische Umgebungstemperatur, durch Messungen durch Temperatursensoren und/oder Wetterdaten zu bestimmen.

13. Überwachungsvorrichtung nach einem der Ansprüche 10 bis 12, wobei mindestens eine Funktionseinheit dazu konfiguriert ist:

- eine Klassifizierung durch mehrere Temperaturbereiche des Energietransportkabels (100) eines Messsegments in Teilabschitte (j) durchzuführen, wobei ein Temperaturbereich eine Ausdehnung kleiner oder gleich 5 °C aufweist,
- partielle theoretische Leckströme nach Teilabschnitten zu bestimmen,
- partielle theoretische Leckströme zu addieren, um den theoretischen Leckstrom (I_leak-theo) eines Messsegments (112C) zu erhalten.

**14.** Überwachungsvorrichtung nach Anspruch 13, wobei die Ausdehnung des Temperaturbereichs innerhalb desselben Teilabschnitts weniger als 2 °C, insbesondere 1,5 °C, beträgt.

**15.** Überwachungsvorrichtung nach einem der Ansprüche 10 bis 14, wobei ein Temperaturparameter die Außentemperatur des elektrischen Energietransportkabels (100) oder die Umgebungstemperatur am Boden entlang des Energietransportkabels (100) eines Messsegments ist.

**16.** Überwachungsvorrichtung nach einem der Ansprüche 10 bis 15, wobei mindestens eine Funktionseinheit dazu konfiguriert ist, mindestens einen Umgebungsparameter aus der folgenden Gruppe genommen bei der Bestimmung durch Berechnung eines theoretischen Leckstroms (I_leak-theo) in einem Messsegment (112C) zu berücksichtigen:

- das Einbettungstiefenprofil des elektrischen Transportkabels,
- das Profil des thermischen Widerstands des Bodens, der das elektrische Transportkabel umgibt,
- das spezifische Wärmeprofil des Bodens, der das elektrische Transportkabel umgibt.

**17.** Überwachungsvorrichtung nach einem der Ansprüche 10 bis 16, wobei mindestens eine Funktionseinheit dazu konfiguriert ist, ein Alterungsmodell, insbesondere die thermischen und/oder elektrischen Eigenschaften des isolierenden Mantels des Energietransportkabels bei der Bestimmung durch Berechnung eines theoretischen Leckstroms (I_leak_theo) in einem Messsegment (112C) zu berücksichtigen.

**Claims**

**1.** A method for monitoring an electrical power transmission system (1) for a DC electrical power transmission network comprising an electrical power transmission cable (100), with:

- an electrically conductive central core (103) configured to transmit an electrical current,
- an insulating jacket (105) electrically disposed around the central core (103),
- a metal shield (107) arranged around the insulating jacket (105),
- grounding connections of the metal shield (107), a measurement segment (112A, 112B, 112C, 112D, 112E) being defined between two successive grounding connections (109), the method comprising the following steps:

- determining, along a measurement segment (112C), at least one profile of a temperature parameter,
- determining a theoretical leakage current (I_leak-theo) between the ground connections (109) of the measurement segment (112C) taking into account the temperature parameter profiles and the load current and voltage,
- measuring the leakage current (I leak-mes) between the ground connections (109) of the measuring segment (112C),
- generating an alert if the difference between the theoretical leakage current (I_leak-theo) and the measured leakage current (I_leak-mes) exceeds a predetermined threshold.

**2.** A monitoring method according to claim 1, wherein at least some temperature parameter profiles, in particular the external temperature of the electrical power transmission cable (100), are determined by measurements with a fibre-optic system (19).

**3.** A monitoring method according to claim 1 or 2, wherein at least certain temperature parameter profiles, in particular the above-ground ambient temperature, are determined by means of measurements by temperature sensors arranged along a measuring segment and/or by means of meteorological data along a measuring segment.

**4.** A monitoring method according to any one of claims 1 to 3, wherein calculating a theoretical leakage current (I_leak_theo) comprises the following steps:

- classifying a measuring segment (112) into sections (j) by a plurality of temperature ranges of the power transmission cable (100), wherein a temperature range has a span of less than or equal to 10°C, in particular less than or equal to 5°C,
- calculating theoretical partial leakage currents per section (j),
- adding the partial theoretical leakage currents to obtain the theoretical leakage current (I_leak_theo) of a measurement segment (112C).

**5.** A monitoring method according to claim 4, wherein the span of the temperature range within a single section is less than 2°C, in particular 1.5°C.

**6.** A monitoring method according to any one of claims 4 or 5, wherein the step of determining by calculation a partial theoretical leakage current per sections is performed at once for sections of the same class after the classification.

7. A monitoring method according to any one of claims 1 to 6 wherein a temperature parameter is the external temperature of the electrical power transmission cable (100) or the temperature measured in the vicinity of the electrical power transmission cable (100) or the ambient temperature on the ground, this along the power transmission cable (100) of a measurement segment (112C).

8. A monitoring process according to any of claims 1 to 6, wherein at least one environmental parameter from the following group is taken into account when calculating a theoretical leakage current (I_leak-theo) in a measurement segment (112C):

- the burial-depth profile of the electrical transmission cable,
- the thermal-resistance profile of the soil surrounding the electrical transmission cable,
- the specific-heat profile of the soil surrounding the electrical transmission cable.

9. A monitoring method according to any one of claims 1 to 8, wherein, when calculating a theoretical leakage current (I_leak-theo) of a measuring segment (112C), an ageing model is taken into account, in particular the thermal and/or electrical properties of the insulating jacket of the power transmission cable.

10. A device (500) for monitoring an electrical power transmission system (1) for a DC electrical power transmission network comprising an electrical power transmission cable (100), with:

- an electrically conductive central core (103) configured to transmit an electrical current,
- an insulating jacket (105) electrically disposed around the central core (103),
- a metal shield (107) arranged around the insulating jacket (105),
- grounding connections of the metal shield (107), with a measurement segment (112A-E) being defined between two successive grounding connections (109),
- the device (500) comprising one or more functional units configured to:

- determine, along a measurement segment (112C, at least one profile of a temperature parameter,
- determine a theoretical leakage current (I_leak-theo) between the ground connections (109) of the measurement segment (112C) taking into account the temperature parameter profiles and the load current and voltage,
- measure the leakage current (I leak-mes) between the ground connections of the measuring segment,
- generate an alert if the difference between the theoretical leakage current (I_leak-theo) and the measured leakage current (I_leak-mes) exceeds a predetermined threshold.

11. A monitoring device according to claim 10, wherein at least one functional unit is configured to determine at least some temperature parameter profiles, in particular the external temperature of the electrical power transmission cable (100), by measurements through a fibre optic system (19).

12. A monitoring device according to claim 10 or 11, wherein at least one functional unit is configured to determine at least some temperature parameter profiles, in particular the above-ground ambient temperature, by means of temperature sensor measurements and/or weather data.

13. A monitoring device according to any one of claims 10 to 12, wherein at least one functional unit is configured to:

- perform a classification by several temperature ranges of the power transmission cable (100) of a measuring segment into sections (j), a temperature range having a span of 5°C or less,
- determine theoretical partial leakage currents per section,
- add partial theoretical leakage currents to obtain the theoretical leakage current (I-leak-theo) of a measurement segment (112C).

14. A monitoring device according to claim 13, wherein the span of the temperature range within a single section is less than 2°C, in particular 1.5°C.

15. A monitoring device according to any one of claims 10 to 14, wherein a temperature parameter is the external temperature of the electrical power transmission cable(100) or the ambient ground temperature along the power transmission cable (100) of a measurement segment.

16. A monitoring device according to any one of claims 10 to 15, wherein at least one functional unit is configured to take into account at least one environmental parameter taken from the following group when calculating a theoretical leakage current (I_leak-theo) in a measurement segment (112C):

- the burial-depth profile of the electrical transmission cable,
- the thermal-resistance profile of the soil surrounding the electrical transmission cable,
- the specific-heat profile of the soil surrounding the electrical transmission cable.

17. A monitoring device according to any one of claims 10 to 16, wherein at least one functional unit is configured to take into account an ageing pattern, in particular the thermal and/or electrical properties of the insulating jacket of the power transmission cable when calculating a theoretical leakage current (I_leak_theo) in a measurement segment (112C).

Fig. 1

Fig. 2

EP 4 150 358 B1

```
┌─────────────────┐
│                 │
│       200       │
│                 │
└─────────────────┘
         │
         ▼
┌─────────────────┐
│                 │
│       202       │
│                 │
└─────────────────┘
         │
         ▼
┌─────────────────┐
│                 │
│       204       │
│                 │
└─────────────────┘
         │
         ▼
┌─────────────────┐
│                 │
│       206       │
│                 │
└─────────────────┘
```

Fig. 3

Fig. 4

EP 4 150 358 B1

Fig. 5

**RÉFÉRENCES CITÉES DANS LA DESCRIPTION**

**Documents brevets cités dans la description**

- WO 2012162486 A

**Littérature non-brevet citée dans la description**

- Distributed Temperature Sensing: Review of Technology and Applications. *IEEE Sensors Journal*, May 2012, vol. 12